# EUROPÄISCHE PATENTSCHRIFT

(11) **EP 0 737 968 B1**
(45) Veröffentlichungstag und Bekanntmachung des Hinweises auf die Patenterteilung: **07.06.2000**
(21) Anmeldenummer: 96105507.6
(22) Anmeldetag: 06.04.1996
(51) Int. Cl.: G11B 7/26, B29D 17/00, B65G 29/00

(54) **Transportvorrichtung**
Transport device
Dispositif de transport

(30) Priorität: 13.04.1995 DE 19514037
(43) Veröffentlichungstag der Anmeldung: 16.10.1996
(73) Patentinhaber: Balzers und Leybold Deutschland Holding Aktiengesellschaft, 63450 Hanau (DE)
(72) Erfinder: Zejda, Jaroslav, 63517 Rodenbach (DE)
(74) Vertreter: Sartorius, Peter, Dipl.-Ing.

(56) Entgegenhaltungen:
- EP-A- 0 354 294
- EP-A- 0 574 975
- WO-A-88/01564
- DE-A- 2 101 335
- DE-A- 4 127 341
- GB-A- 2 133 764
- GB-A- 2 250 495

## Beschreibung

**Die Erfindung bezieht sich auf** eine Transportvorrichtung zur Beförderung von Substraten, die mit einer Ausgangsstation und mehreren in Reihe oder kreisförmig angeordneten Prozeßstationen zur Aufnahme des Substrats ausgestattet ist, zu denen das Substrat mittels der als kreisrunder Drehtisch ausgebildeten Transportvorrichtung geleitet und dann an eine Aufnahme- und/oder Übergabestation abgegeben wird, der antreibbare Substratgreifer zur Aufnahme und Übergabe des Substrats vom Drehtisch zugeordnet sind.

**Es ist bereits eine Vorrichtung** zum selbsttätigen Gießen, Beschicken, Lackieren, Prüfen und Sortieren von Werkstücken aus der DE 41 27 341 A1 bekannt, zu der mehrere Bearbeitungsstationen gehören. Insbesondere weist diese Vorrichtung eine Substrattransporteinrichtung mit einem längs einer geraden Linie hin und her bewegbaren Transportschlitten auf, dem weitere Schlitten mit Transporttragarmen zugeordnet sind. Neben der ersten Transportvorrichtung ist eine weitere als Drehtisch ausgebildete Transporteinrichtung vorgesehen, die zahlreiche Stationen aufweist, auf denen die Substrate abgelegt werden können. Die als Drehtisch ausgebildete Transportvorrichtung wird mittels des geradlinig arbeitenden Transportschlittens mit Substraten beschickt. Jeder zweiten bzw. jeder dritten Station ist eine Prozeßstation zugeordnet, in der die einzelnen Substrate behandelt werden, bis sie schließlich an einer Ablagestation ausgestoßen werden. Die Übergabe des Substrats zwischen der Aufnahmestation und dem Drehtisch bzw. zwischen dem Drehtisch und den entsprechenden Prozeßstationen der geradlinig arbeitenden Transportvorrichtung erfolgt über in ihrer Höhe verstellbare Substratgreifer. Da nicht jeder Ablagestation eine Prozeßstation zugeordnet ist, arbeitet eine derartige Transportvorrichtung zumindest zeitweise im Leerlauf. Außerdem benötigt eine derartige Anlage sehr viel Platz, insbesondere durch die geradlinig arbeitende Transportvorrichtung.

Ferner ist eine Transportvorrichtung zur Beförderung von Substraten bekannt (EP 0 574 975 A1), zu der eine Ausgangsstation und mehrere kreisförmig angeordnete Prozeßstationen zur Aufnahme von Substraten gehören, denen das Substrat mittels der als Drehtisch ausgebildeten Transportvorrichtung zugeleitet und dann an eine Aufnahme- und/oder Übergabestation abgegeben wird, wobei die Aufnahme und Übergabe des Substrats vom Drehtisch mittels antreibbarer Substratgreifer erfolgt, wobei der Drehtisch in einer gleichbleibenden Taktfrequenz angetrieben wird und das Substrat mittels des drehbar gelagert ausgebildeten Substratgreifers einer außerhalb des Drehtisches vorgesehenen Prozeßstation zugeführt werden kann. Da nicht jeder Ablagestation eine Prozeßstation zugeordnet ist, arbeitet eine derartige Transportvorrichtung zumindest teilweise im Leerlauf. Außerdem benötigt eine derartige Anlage sehr viel Platz, insbesondere durch die geradlinig ausgebildete Transportvorrichtung, die die Substrate dem Drehtisch zuführt.

**Der Erfindung liegt die Aufgabe zugrunde**, die Transportvorrichtung und die einzelnen Stationen zur Aufnahme des Substrats auf kleinstmöglichem Raum unterzubringen.

**Gelöst wird die Aufgabe bei einer eingangs genannten Transportvorrichtung erfindungsgemäß dadurch,** daß einer jeden Aufnahmestation des Drehtisches eine Prozeßvorrichtung zugeordnet sein kann, daß der Drehtisch mit einer gleichbleibenden Taktfrequenz angetrieben wird, wobei sich die Taktfrequenz nach einer beliebigen Prozeßstation mit der längsten Arbeitszeitdauer richtet, und daß mehrere gegenüber dem Drehtisch drehbar gelagerte, mindestens zweiarmig ausgebildete Substratgreifer vorgesehen sind, die zur Zufuhr von Substraten zu den im Bereich der Peripherie des Drehtisches vorgesehenen Prozeßstationen dienen. Durch die Verwendung des kreisförmig ausgebildeten Drehtisches in Verbindung mit den schwenk- und höhenverstellbar ausgebildeten Substratgreifern lassen sich an der Peripherie des Drehtisches zahlreiche Prozeßstationen platzsparend unterbringen. Somit wird auch die Möglichkeit geschaffen, daß jeder Ablagestation eine Prozeßstation bzw. Prozeßvorrichtung zugeordnet werden kann. Die Übergabe des Substrats zwischen der Prozeßstation und der Ablagestation kann, soweit dies erforderlich ist, über die drehbar gelagerten Substratgreifer erfolgen. Außerdem ist es möglich, daß die Prozeßstationen so weit über den Drehtisch ragen, daß diese von unten her die einzelnen Prozeßstationen bzw. Arbeitsvorrichtungen durchfahren. Da der Drehtisch in einer annähernd gleichen Taktfrequenz angetrieben wird, lassen sich die Substrate kurzfristig genau unter den einzelnen Prozeßvorrichtungen plazieren, und zwar so lange, bis jeder Arbeitsvorgang ausgeführt ist. Danach wandert das Substrat zur nächsten Prozeßstation. Da auf jeder Ablagestation ein Substrat abgelegt und gleichzeitig auch jeder Ablagestation die Prozeßvorrichtung zugeordnet werden kann, entstehen keine Leerlaufzeiten.

Ferner ist es vorteilhaft, daß der Substratgreifer zwei oder mehrarmig ausgebildet und drehbar und höhenverstellbar im Bereich der Transportvorrichtung gelagert ist. Durch den schwenkbar ausgebildeten Substratgreifer lassen sich die an der Peripherie des kreisförmig ausgebildeten Drehtisches angeordneten Prozeßstationen ohne weiteres beschicken. Der Substrathalter muß hierzu lediglich mit zwei oder mehreren Tragarmen ausgerüstet sein, so daß er für die Substratübergabe zwischen Prozeßstation und Ablagestation lediglich kurzfristig angehoben, um 180° geschwenkt und dann wieder abgesenkt werden kann.

In weiterer Ausgestaltung der Erfindung ist es vorteilhaft, daß der drehbar gelagerte Substratgreifer an der Peripherie des Drehtisches angeordnet ist.

Sollte der Arbeitsprozeß an einer Ablagestation sehr zeitaufwendig sein, so kann beispielsweise die Bearbeitungszeit dadurch halbiert werden, daß das Substrat außerhalb des Drehtisches an zwei getrennten, parallel zusammenwirkenden Satelliten-Arbeitsstationen bearbeitet wird. Nach diesem Vorgang wird das Substrat von den außerhalb des Drehtisches vorgesehenen Prozeßstationen wieder dem kreisförmig ausgebildeten Drehtisch zugeführt. Hierzu ist es vorteilhaft, daß zur Verkürzung der Taktfrequenz des Drehtisches der Substratgreifer jeweils ein Substrat einer oder mehreren außerhalb des Drehtisches vorgesehenen, parallel oder hintereinander geschalteten Prozeßstationen zuführt, auf denen gleiche oder unterschiedliche Arbeitsprozesse durchgeführt werden.

Von besonderer Bedeutung ist für die vorliegende Erfindung, daß auf dem Drehtisch zumindest so viele Aufnahmestationen vorgesehen sind, wie Prozeßstationen zur Aufnahme des Substrats notwendig sind, die alle zur vollständigen Bearbeitung des Substrats benötigt werden. Da alle Aufnahmestationen des Drehtisches mit einem Substrat belegt werden können, erhält man eine sehr kompakte Anlage.

Vorteilhaft ist es ferner, daß zur Verkürzung der Taktfrequenz des Drehtisches gleichzeitig zwei oder mehrere gleiche Arbeitsprozesse parallel auf zwei oder mehreren nebeneinander liegenden Prozeßstationen durchgeführt werden können. Hierdurch kann je nach Bedarf die Arbeitszeit zur vollständigen Herstellung eines Substrats insgesamt verringert werden, wenn in bestimmten Fällen Bearbeitungsvorgänge nicht auf dem Drehtisch direkt vorgenommen werden sollen. Mittels des Substratgreifers lassen sich in einem derartigen Fall die Substrate vom Drehtisch abnehmen und, wie bereits erwähnt, einer außerhalb des Drehtisches vorgesehenen Prozeßstation zuführen. Hierzu ist es vorteilhaft, daß im Bereich der Ausgangsstation, der Beschichtungsstation, der Druckstation und/oder Ausgabestation ein ein- oder mehrarmiger Greiferarm vorgesehen ist, der das Substrat vom Drehtisch zur Satellitenstation oder umgekehrt weiterleitet.

Ferner ist es vorteilhaft, daß dem ersten Drehtisch ein oder mehrere Drehtische zugeordnet sind, auf denen die vom ersten Drehtisch kommenden Substrate abgenommen und zur weiteren Bearbeitung kurzfristig dem zweiten Drehtisch zugeführt werden, um dann anschließend wieder auf den ersten Drehtisch zurückgeführt oder einem anderen Drehtisch bzw. einer Ausgabestation zugeführt zu werden. Soll beispielsweise das Substrat einer besonderen Bearbeitung unterzogen werden, die am Drehtisch aus Platzgründen nicht durchführbar ist, so kann das Substrat von einem Drehtisch zu einem anderen Drehtisch weitergeleitet werden, der ebenfalls in einer bestimmten Taktfrequenz angetrieben wird und mit entsprechenden Prozeßstationen ausgestattet ist. Nach dem Arbeitsvorgang auf dem außerhalb des zentralen Drehtisches vorgesehenen zweiten Drehtisch kann das Substrat nach seiner Zwischenbehandlung wieder auf den ursprünglichen zentralen Drehtisch zurückgeführt werden. Dadurch wird die Taktzeit des zentralen Drehtisches ebenfalls günstig beeinflußt, insbesondere dann, wenn sehr lange Arbeitsprozesse am Substrat durchgeführt werden müssen.

Es ist auch denkbar, daß in bestimmten Fällen der Drehtisch mit Parkstationen ausgestattet ist, an denen keine Bearbeitung des Substrats erfolgt. Ferner besteht die Möglichkeit, die Parkstationen außerhalb des Drehtisches vorzusehen.

Die Übergabe zwischen den einzelnen Drehtischen erfolgt wiederum durch die vorteilhafte Anordnung der Substratgreifer. Hierzu sind vorteilhafterweise die weiteren Drehtische im Bereich der Peripherie des zentralen Drehtisches und die Parkstationen, denen ein oder mehrere Substratgreifer zugeordnet sind, auf einem zweiten im Bereich der Peripherie des ersten Drehtisches vorgesehenen Drehtisch angeordnet.

In weiterer Ausgestaltung der Erfindung ist es vorteilhaft, daß die Abstände zwischen den einzelnen Aufnahmestationen auf dem Drehtisch gleich oder unterschiedlich groß sind und jeder Substratgreifer mehrere Substrate hintereinander oder gleichzeitig aufnehmen kann und dadurch die Substrate zwischen den einzelnen Stationen weiterbewegt bzw. die Substrate von einer Station aufnimmt und an eine andere Station weitergibt. Da ein mehrarmiger Substratgreifer jeweils am Ende der einzelnen Tragarme Aufnahme- bzw. Saugelemente aufweist, lassen sich über einen einzelnen Substratgreifer zwei oder mehrere Substrate aufnehmen und kurzfristig einer anderen Prozeßstation oder auch der Ablagestation zuführen.

Eine zusätzliche Möglichkeit gemäß einer Weiterbildung der erfindungsgemäßen Transportvorrichtung besteht darin, daß der Substratgreifer horizontal und/oder vertikal verschwenkbar und/oder höhenverstellbar gelagert ist und die Substratgreifer in Abhängigkeit der Drehbewegung bzw. der Taktfrequenz des Drehtisches gesteuert werden und ihre Arbeitsbewegung ausführen. Durch die verschiedenartige Verstellmöglichkeit des Substratgreifers können auch die einzelnen Prozeßstationen, Aufnahme- oder Ablagestationen auf unterschiedlichen Ebenen vorgesehen werden.

Damit eine genaue Abstimmung zwischen den einzelnen Bewegungen der Geräteteile erreicht wird, ist es vorteilhaft, daß der Drehtisch zahlreiche bzw. vier bis zehn bzw. sieben bis neun bzw. acht Aufnahmestationen aufweist und daß jeder Aufnahmestation eine Prozeßstation bzw. eine Umschichtposition zugeordnet ist, von der aus das Substrat an eine außerhalb des Drehtisches vorgesehene Station weitergegeben wird bzw. von dieser Station das Substrat erhält.

Eine wesentliche vorteilhafte Ausführungsform erreicht man dadurch, daß der Beschichtungsstation und der Druckstation ein zweiarmiger Substratgreifer und der Ablagestation ein zwei- oder dreiarmiger Substratgreifer zugeordnet wird.

Ferner ist es vorteilhaft, daß der Drehtisch einem Gehäuse zugeordnet ist, das zur Erzeugung eines Überdrucks an eine Pumpenstation angeschlossen ist. Da der Drehtisch und die einzelnen Prozeßstationen innerhalb eines Gehäuses angeordnet werden, kann das Gehäuse mit Druckluft beaufschlagt werden, die nur über einen Filter zugeführt wird, so daß eine höchstmögliche Reinheit an der Substratoberfläche gewährleistet ist und sich dort keine Schmutzpartikel absetzen.

Ferner ist es vorteilhaft, daß der Drehtisch als kreisförmige Scheibe ausgebildet ist, daß der Drehtisch eine ebene Oberfläche aufweist und daß der Drehtisch mit Bezug auf die Standfläche der Vorrichtung horizontal verlaufend angeordnet ist.

**Weitere Vorteile und Einzelheiten der Erfindung sind in den Patentansprüchen** und in der Beschreibung erläutert und in den Figuren dargestellt. Es zeigt:
- Figur 1: eine perspektivische Darstellung der erfindungsgemäßen Vorrichtung mit einem kreisförmig angeordneten Drehtisch und den einzelnen Prozeßstationen bzw. Bearbeitungsvorrichtungen,
- Figur 2: eine schematische Darstellung der Vorrichtung gemäß Figur 1 in Draufsicht.

In der Zeichnung ist mit 1 eine Transportvorrichtung zur Beförderung von Substraten bezeichnet, der einzelne nachstehend näher beschriebene Prozeßstationen bzw. Bearbeitungsvorrichtungen 4-9 zugeordnet sind.

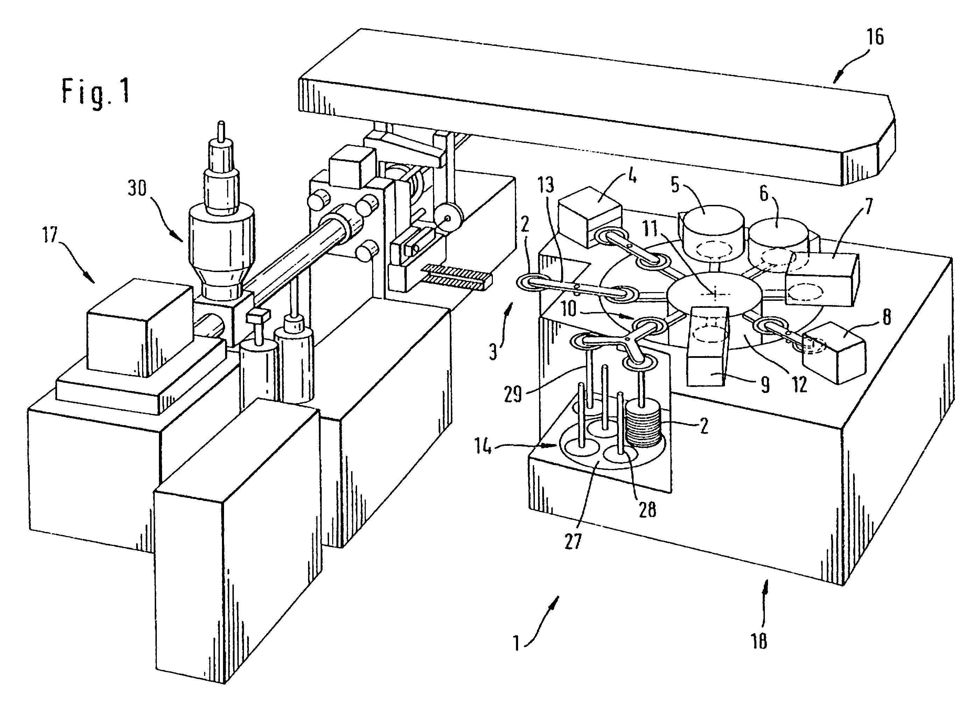

Die in Figur 1 dargestellte Gesamtvorrichtung bzw. Transportvorrichtung 1 dient zur vollautomatischen Herstellung von Compact-Disks (CD) 2. Der Produktionsablauf der CD-Herstellung erfolgt in einzelnen Prozeßschritten. Die erfindungsgemäße Gesamtanlage besteht aus zwei Hauptteilen 17 und 18. Der Hauptteil 17 enthält eine Spritzgußmaschine 30 und eine Übergabestation bzw. Ausgangsstation 3. An der Ausgangsstation 3 erfolgt die Eingabe eines Substrats 2 in dem zweiten Teil der Anlage bzw. dem Hauptteil 18. Hierzu ist zwischen dem Hauptteil 17 und dem Hauptteil 18 bzw. einer Transportvorrichtung 1 zum Befördern von Substraten 2 ein Substratgreifer 13 vorgesehen.

Der Substratgreifer 13 sowie auch alle anderen Prozeßstationen bzw. Bearbeitungsvorrichtungen 4-9 sind innerhalb eines Gehäuses 16 angebracht, das allseitig verschließbar ist und über eine in der Zeichnung nicht dargestellte Filtereinrichtung mit Druckgas bzw. Druckluft beaufschlagt werden kann, um auf diese Weise eine höchst mögliche Reinheit an der Oberfläche des Substrats zu erzielen.

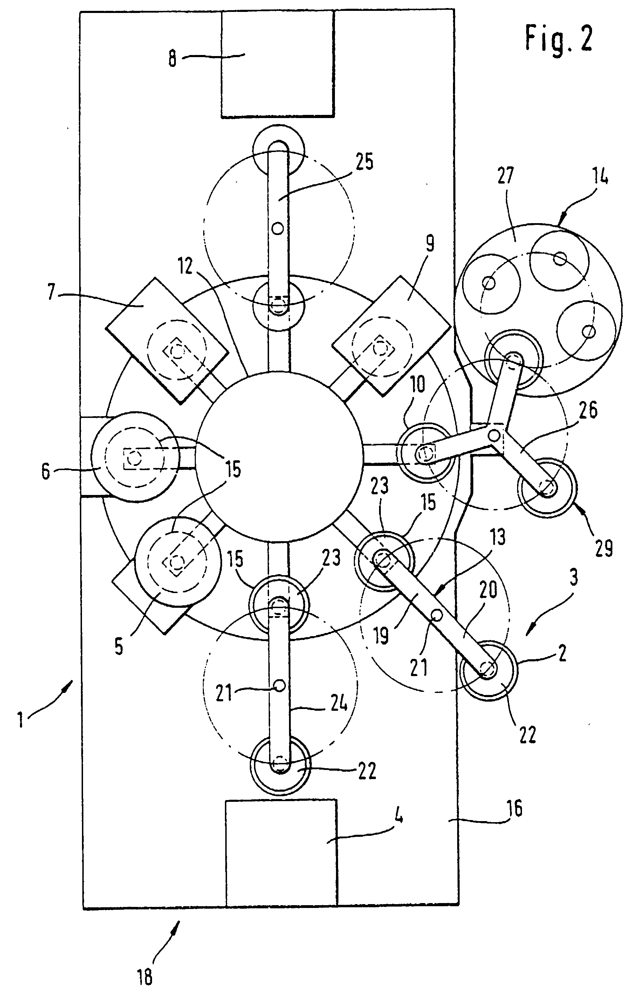

Wie aus der perspektivischen Darstellung gemäß Figur 1 und der Draufsicht gemäß Figur 2 hervorgeht, ist innerhalb des Gehäuses 16 ein kreisförmiger Drehtisch 12 vorgesehen, der mittels einer Drehachse 11 im Gehäuse 16 gelagert und über eine in der Zeichnung nicht dargestellte Steuer- bzw. regelbare Antriebsvorrichtung in Drehbewegung versetzt wird. Die Antriebsvorrichtung wird so gesteuert, daß der Drehtisch 12 impulsartig bzw. mit einer bestimmten Taktfrequenz angetrieben wird, wobei die Taktfrequenz durch die Zeitdauer bestimmt wird, die der längsten Zeitdauer an einer Prozeßstation zur Bearbeitung des Substrats bzw. der CD 2 entspricht.

Auf dem Drehtisch 12 befinden sich in äquidistanter Verteilung und in kreisförmiger Anordnung zahlreiche Aufnahmestationen 15, die in etwa dem Kreisdurchmesser einer CD entsprechen und die mit Hilfe von pneumatischen Vorrichtungen festgesetzt werden können.

Wie bereits erwähnt, wird das Substrat 2 an der Ausgangsstation bzw. an der Übergabestation 3 aus dem Hauptteil 17 über den zweiarmig ausgebildeten Substratgreifer 13 an die Aufnahmestation 15 auf dem Drehtisch 12 weitergegeben. Der Substratgreifer 13 besteht aus zwei Tragarmen 19 und 20, die mittels einer Drehachse 21 an Wandelementen des Gehäuses 16 drehbar aufgenommen sind. Am Ende eines jeden Armes 19 bzw. 20 befindet sich ein Greifelement oder Saugelement 22, 23, so daß mittels des Substratgreifers 13 gleichzeitig zwei CD erfaßt werden. Das eine Greifelement 22 befindet sich gemäß Ausführungsbeispiel Fig. 2 im Bereich der Übergabestelle 3 des Substrats 2 aus dem Hauptteil 17, während das zweite Greifelement 23 sich oberhalb der Aufnahmestation 15 des Drehtisches 12 befindet. Auf diese Weise kann mittels des Substratgreifers 13 einerseits ein Substrat 2 aufgenommen, andererseits ein Substrat 2 auf dem Drehtisch 12 abgelegt werden. Für den nächsten Arbeitsprozeß zur Übergabe des Substrats zwischen den Hauptteilen 17 und 18 wird der Substratgreifer 13 um 180° geschwenkt.

Von der Ausgangsstation 3 wird das Substrat 2 durch den schrittweisen Antrieb des Drehtisches 12 über diesen zur nächsten Prozeßstation bzw. vor die Bearbeitungsstation 4 geleitet. Im Ausführungsbeispiel ist als Bearbeitungsvorrichtung 4 die Vakuumbeschichtungseinrichtung bzw. die Sputtereinrichtung 4 dargestellt, die ebenfalls über einen zweiarmigen Substratgreifer 24 beschickt wird. Wie aus Figur 2 hervorgeht, liegt das eine Greifelement 22 außerhalb der Peripherie des Drehtisches 12, so daß durch Aufnahme der CD mittels des Greifelementes 23 des Substratgreifers 24 das Substrat 2 von dem Drehtisch 12 an die Prozeßstation bzw. Vakuumbeschichtungseinrichtung 4 weitergegeben werden kann. Nach dem Beschichtungsvorgang wird das Substrat 2 aus der Vakuumbeschichtungseinrichtung 4 4 mittels des Greifelementes 22 des Substratgreifers 24 wieder entnommen und gleichzeitig ein neues Substrat 2 von dem Drehtisch 12 über das Greifelement 23 der Vakuumbeschichtungseinrichtung 4 zugeführt. Hierzu wird der Substratgreifer 24 wiederum um 180° geschwenkt.

An die Prozeßstation 4 schließt sich die Prozeßstation 5 an, in der die Lackaufgebung auf die Oberfläche des Substrats 2 erfolgt. Die Lackaufgebung in der Prozeßstation 5 geschieht mittels eines Rotations-Lackaufgebungsverfahrens.

Der Prozeßstation 5 ist die Prozeßstation 6 direkt nachgeschaltet, so daß das Substrat 2 nach der ersten Lackaufgebung bei der Prozeßstation 5 in der Prozeßstation 6 weiterbehandelt wird. Durch eine nicht dargestellte Lackschleudereinrichtung wird eine gleichmäßige Verteilung der Lacke auf der Oberfläche des Substrats 2 bzw. der CD erzielt. Die beiden Prozeßstationen 5 und 6, die in Figur 1 und 2 lediglich schematisch angedeutet sind, befinden sich ebenfalls oberhalb bzw. im Breich des Drehtisches 12, so daß die Beschickung der Prozeßstationen 5 und 6 durch Drehen des Drehtisches 12 in Verbindung mit einem Substratgreifer erfolgen kann.

Nachdem die Lackaufgebung in der Prozeßstation 6 abgeschlossen ist, dreht der Drehtisch 12 das Substrat zur nächsten Prozeßstation 7, die als multifunktionale Trockenvorrichtung ausgebildet ist.

Nach dem Trocknungs- bzw. Härtungsvorgang der Substratoberfläche wird das Substrat 2 mittels des Drehtisches 12 an die nächste Prozeßstation 8 weitergeleitet, die als Druckstation ausgebildet ist, mit der der Aufdruck auf die Oberfläche des Substrats 2 erfolgt. Die Druckeinrichtung 8 kann ebenfalls außerhalb der Peripherie des Drehtisches 12 vorgesehen sein. Die Beschickung der Druckeinrichtung 8 erfolgt ebenfalls über einen Substratgreifer 25, der ähnlich wie der Substratgreifer 13 bzw. 24 ausgebildet ist und der zwischen zwei Stationen, und zwar einer Aufnahme- und einer Übergabestation, drehbar angeordnet ist. Über den Substratgreifer 25 wird also das Substrat 2 der Druckstation 8 zugeführt, in der der Beschriftungsvorgang ausgeführt wird.

Nach diesem Arbeitsprozeß wird das Substrat 2 über den Substratgreifer 25 wieder der Aufnahmestation 15 des Drehtisches 12 und nach einem weiteren Arbeitstakt mittels des Drehtisches 12 der letzten Prozeßstation 9 zugeführt, die als Kontrollstation ausgebildet ist. Mittels der Kontrollstation 9 erfolgt eine genaue Überprüfung der Qualität des Substrats 2. Die Substrate 2 bzw. CD, die den Qualitätsanforderungen nicht entsprechen, werden über einen dreiarmigen Substratgreifer 26 erfaßt, aussortiert, von den den Standard erfüllenden Substraten 2 selektiert und in eine Ablagestation 29 abgegeben. Neben der Ablagestation 29 befindet sich eine weitere Ablagestation 14, auf der einwandfreie Qualität aufweisende CD abgelegt werden. Die Ablagestation 14 besteht hierzu aus einem Drehteller 27 mit beispielsweise vier verschiedenen Stiften 28 zur Aufnahme der einzelnen Substrate 2 bzw. CD.

Wie aus den Figuren 1 und 2 hervorgeht, sind die einzelnen Prozeßstationen 4-9 sowie die Ausgangsstation 3 und eine Ausgabestation 10 zum Sammeln der Substrate 2 auf einer Kreisperipherie angeordnet, wobei jeder einzelnen Aufnahmestation 15 eine entsprechende Prozeßstation zugeordnet ist, so daß die gesamte Einrichtung mit allen Prozeßstationen auf sehr kleinem Raum in dem Gehäuse 16 untergebracht werden kann.

Zur Verkürzung der Taktfrequenz des Drehtisches 12 kann der Substratgreifer jeweils ein Substrat 2 einer oder mehreren außerhalb des Drehtisches 12 vorgesehenen parallel oder hintereinander geschalteten nur teilweise dargestellten Satelliten-Prozeßstationen zuführen, auf denen gleiche oder unterschiedliche Arbeitsprozesse durchgeführt werden können. Die Prozeßstation 4 kann auch als Satelliten-Prozeßstationen angesehen werden. Es können aber auch zusätzliche in der Zeichnung nicht dargestellte Satelliten-Prozeßstationen vorgesehen werden Auf diese Weise kann die Taktfrequenz des Drehtisches reduziert werden, da die Bearbeitungszeiten außerhalb des Drehtisches 12 durchgeführt werden können. Eine derartige zusätzliche Anordnung eines Drehtisches ist in der Anmeldung P 44 08 537.0 in Figur 1 dargestellt. Nach dieser Anordnung können über die zweiarmigen Dreharme die Substrate von einem Drehtisch auf einen außerhalb der Peripherie des ersten Drehtisches vorgesehenen weiteren Drehtisch geleitet werden und umgekehrt.

In vorteilhafter Weise weist gemäß Figur 1 und 2 der Drehtisch 12 genauso viele Aufnahmestationen 15 auf, wie Arbeitsprozeßschritte durchgeführt werden sollen. Auf diese Weise kann auf kleinstem Raum eine sehr große Anzahl von Aufnahmestationen 15 auf dem Drehtisch untergebracht werden. Im Ausführungsbeispiel befinden sich auf dem Drehtisch 12 acht Aufnahmestationen, denen je eine Prozeßstation bzw. Aufgabe- und Abnahmestation zugeordnet ist.

Zur Verkürzung der Taktfrequenzen des Drehtisches 12 können auch länger dauernde Arbeitsprozesse an Substraten 2 parallel ausgeführt werden. Hierzu ist ein zweiarmiger in der Zeichnung nicht dargestellter Substratgreifer vorgesehen, der gleichzeitig zwei Substrate 2 von dem Drehtisch 12 abnimmt und diese mehreren Bearbeitungsstationen zuführt, an denen dann die Bearbeitung parallel ausgeführt wird. Da jeweils zwei Substrate gleichzeitig bearbeitet werden, kann die Taktzeit hiermit um 50% oder mehr reduziert werden. Dies ist inbesondere dann von Vorteil, wenn der Arbeitsprozeß an einer Stelle äußerst lange dauert. Derartige Prozeßstationen werden, wie bereits erwähnt, als Satellitenstationen bezeichnet. Obwohl es gemäß der Erfindung vorteilhaft ist, keine Parkstationen auf dem Drehtisch 12 vorzusehen, ist es jedoch möglich, je nach Arbeitsablauf auch eine zusätzliche Parkstation zwischen den acht Prozeßstationen einzurichten, auf der ein Substrat 2 abgelegt werden kann. Die Parkstation, die in der Zeichnung nicht dargestellt ist, kann sich entweder auf dem Drehtisch oder außerhalb des Drehtisches befinden.

In vorteilhafter Weise sind die Abstände zwischen den einzelnen Aufnahmestationen 15 gleich groß. Im Ausführungsbeispiel wird die Taktfrequenz bzw. Zykluszeit nach der längsten Arbeitsdauer einer Prozeßstation ausgerichtet. Im Ausführungsbeispiel beträgt sie z. B. 4 sec. Obwohl dies im Ausführungsbeispiel nicht weiter veranschaulicht wird, kann der Substratgreifer horizontal, vertikal und höhenverstellbar gelagert sein, um den Transport der Substrate zwischen den einzelnen Stationen so einfach wie möglich zu gestalten. Durch die Taktfrequenz des Drehtisches 12 wird auch die Drehgeschwindigkeit der einzelnen Substratgreifer gesteuert, so daß ein kontinuierlicher, abgestimmter Prozeßablauf gewährleistet ist.

Durch die vorteilhafte kompakte Anordnung des Drehtisches 12 mit den dicht nebeneinander angeordneten Aufnahmestationen 15, denen jeweils, wie bereits erwähnt, eine Prozeßstation zugeordnet ist, erhält man z. B. Taktzeiten von 4 Sekunden zur Herstellung des Substrats 2 bzw. einer CD. Dies wird insbesondere dadurch erreicht, daß an allen Stationen die einzelnen Arbeitsprozesse parallel ablaufen. Wird dem Drehtisch 12 eine neue CD 2 zur Bearbeitung zugeführt, so wird gleichzeitig eine fertiggestellte CD innerhalb der erwähnten Taktzeit von 4 Sekunden ausgestoßen. Das heißt, bei acht Prozeßstationen beträgt eine Taktzeit maximal 0,5 sec um das Substrat 2 von einer Bearbeitungsstelle zu einer weiteren Bearbeitungsstelle zu befördern, so daß die längste Prozeßdauer an einer Arbeitsstation nicht größer als 3,5 sec sein darf. Mit der erwähnten Anlage ist eine sehr niedrige Taktfrequenz zu erreichen. Die Zykluszeit an einer Station ergibt sich aus der Prozeßdauer des längsten Arbeitsprozesses plus der Förderzeit zwischen zwei Prozeßstationen auf dem Drehtisch. Diese Taktzeit beträgt, wie erwähnt, 0,5 Sekunden wobei die Ausstoßgeschwindigkeit der CD 2 der Zykluszeit entspricht. Folglich werden die CD auch in der gleichen Schnelligkeit von der Anlage 17 zur Anlage 18 geführt. Die Taktfrequenz kann durch Verkürzung der Prozeßzeiten weiter reduziert werden.

Der Drehtisch 12 kann als kreisförmige Scheibe ausgebildet sein und eine ebene Oberfläche aufweisen. Mit Bezug auf die Standfläche der Vorrichtung ist der Drehtisch 12 vorteilhafterweise horizontal verlaufend angeordnet.

### Bezugszeichenliste

- 1: Transportvorrichtung zur Beförderung von Substraten
- 2: Substrat = CD
- 3: Ausgangsstation = Übergabestation = Aufnahmestation Eingabe des Substrats
- 4: Prozeßstation, Bearbeitungsvorrichtung= Vakuumbeschichtungseinrichtung
- 5: Prozeßstation, Lackauftragung
- 6: Prozeßstation, Lackschleudereinrichtung
- 7: Prozeßstation, Lacktrocknung
- 8: Prozeßstation, Druckeinrichtung, Satellitenstation
- 9: Prozeßstation, Kontrollstation
- 10: Ausgabestation, Sammeln des Substrats 2, Aufnahmestation
- 11: Drehachse
- 12: Drehtisch
- 13: Substratgreifer, ein- oder mehrarmiger Greiferarm
- 14: Ablagestation für CD mit guter Qualität
- 15: Aufnahmestation
- 16: Gehäuse
- 17: Hauptteil
- 18: Hauptteil
- 19: Tragarm
- 20: Tragarm
- 21: Achse
- 22: Greifelement, Saugelement
- 23: Greifelement
- 24: Substratgreifer = Greifelement
- 25: Substratgreifer
- 26: Substratgreifer
- 27: Drehteller
- 28: Stift
- 29: Ablagestation für CD mit schlechter Qualität
- 30: Spritzgußmaschine

## Patentansprüche

1. Transportvorrichtung (1) zur Beförderung von Substraten (2), die mit einer Ausgangsstation (3) und mehreren in Reihe oder kreisförmig angeordneten Prozeßstationen (4 bis 9) zur Aufnahme des Substrats (2) ausgestattet ist, zu denen das Substrat (2) mittels der als kreisrunder Drehtisch (12) ausgebildeten Transportvorrichtung (1) geleitet und dann an eine Aufnahme- und/oder Übergabestation (15) abgegeben wird, der antreibbare Substratgreifer (13) zur Aufnahme und Übergabe des Substrats vom Drehtisch (12) zugeordnet sind, **dadurch gekennzeichnet**, daß einer jeden Aufnahmestation (15) des Drehtisches eine Prozeß-vorrichtung (4 bis 9) zugeordnet sein kann, daß der Drehtisch (12) mit einer gleichbleibenden Taktfrequenz angetrieben wird, wobei sich die Taktfrequenz nach einer beliebigen Prozeßstation mit der längsten Arbeitszeitdauer richtet, und daß mehrere gegenüber dem Drehtisch drehbar gelagerte, mindestens zweiarmig ausgebildete Substratgreifer (13) vorgesehen sind, die zur Zufuhr von Substraten zu den im Bereich der Peripherie des Drehtisches (12) vorgesehenen Prozeßstationen dienen.

2. Transportvorrichtung nach Anspruch 1, **dadurch gekennzeichnet**, daß der Substratgreifer (13) zwei- oder mehrarmig ausgebildet ist.

3. Transportvorrichtung nach Anspruch 1 oder 2, **dadurch gekennzeichnet,** daß der Substratgreifer (13) drehbar und höhenverstellbar im Bereich der Transportvorrichtung (1) gelagert ist.

4. Transportvorrichtung nach Anspruch 1, **dadurch gekennzeichnet,** daß der drehbar gelagerte Substratgreifer (13) an der Peripherie des Drehtisches (12) angeordnet ist.

5. Transportvorrichtung nach einem der vorhergehenden Ansprüche, **dadurch gekennzeichnet,** daß zur Verkürzung der Taktfrequenz des Drehtisches (12) der Substratgreifer (13) jeweils ein Substrat (2) einer oder mehreren außerhalb des Drehtisches (12) vorgesehenen, parallel oder hintereinander geschalteten Prozeßstationen zuführt, auf denen gleiche oder unterschiedliche Arbeitsprozesse durchgeführt werden.

6. Transportvorrichtung nach Anspruch 1, **dadurch gekennzeichnet,** daß auf dem Drehtisch (12) zumindest so viele Aufnahmestationen (15) vorgesehen sind, wie Prozeßstationen zur Aufnahme des Substrats (2) notwendig sind, die alle zur vollständigen Bearbeitung des Substrats (2) benötigt werden.

7. Transportvorrichtung nach einem der vorhergehenden Ansprüche, **dadurch gekennzeichnet,** daß zur Verkürzung der Taktfrequenz des Drehtisches (12) gleichzeitig zwei oder mehrere gleiche Arbeitsprozesse parallel auf zwei oder mehreren nebeneinander liegenden Prozeßstationen durchgeführt werden können.

8. Transportvorrichtung nach einem der vorhergehenden Ansprüche, **dadurch gekennzeichnet,** daß im Bereich der Ausgangsstation (3), einer Beschichtungsstation (4), einer Druckstation (9) und/oder Ausgabestation (10) ein zwei- oder mehrarmiger Greiferarm (13) vorgesehen ist, der das Substrat (2) vom Drehtisch (12) zur Satellitenstation oder um. gekehrt weiterleitet.

9. Transportvorrichtung nach einem der vorhergehenden Ansprüche, **dadurch gekennzeichnet,** daß dem ersten Drehtisch (12) ein oder mehrere Drehtische zugeordnet sind, auf denen die vom ersten Drehtisch (12) kommenden Substrate (2) abgenommen und zur weiteren Bearbeitung kurzfristig dem zweiten Drehtisch zugeführt werden, um dann anschließend wieder auf den ersten Drehtisch (12) zurückgeführt oder einem anderen Drehtisch bzw. einer Ausgabestation (10) zugeführt zu werden.

10. Transportvorrichtung nach einem der vorhergehenden Ansprüche, **dadurch gekennzeichnet,** daß der Drehtisch (12) eine oder mehrere Parkstationen aufweist, an denen keine Bearbeitung des Substrats erfolgt.

11. Transportvorrichtung nach Anspruch 10, **dadurch gekennzeichnet**, daß die Parkstationen außerhalb des Drehtisches (12) vorgesehen sind.

12. Transportvorrichtung nach einem der Ansprüche 10 oder 11, **dadurch gekennzeichnet**, daß die Parkstationen, denen ein oder mehrere Substratgreifer zugeordnet sind, auf einem zweiten im Bereich der Peripherie des ersten Drehtisches vorgesehenen Drehtisch angeordnet sind.

13. Transportvorrichtung nach einem der vorhergehenden Ansprüche, **dadurch gekennzeichnet,** daß die Abstände zwischen den einzelnen Aufnahmestationen (15) auf dem Drehtisch (12) gleich oder unterschiedlich groß sind.

14. Transportvorrichtung nach einem der vorhergehenden Ansprüche, **dadurch gekennzeichnet,** daß jeder Substratgreifer (13) mehrere Substrate (2) hintereinander oder gleichzeitig aufnehmen kann und dadurch die Substrate zwischen den einzelnen Stationen weiterbewegt bzw. die Substrate von einer Station aufnimmt und an eine andere Station weitergibt.

15. Transportvorrichtung nach einem der vorhergehenden Ansprüche, **dadurch gekennzeichnet,** daß der Substratgreifer (13) horizontal und/oder vertikal verschwenkbar und/oder höhenverstellbar gelagert ist.

16. Transportvorrichtung nach einem der vorhergehenden Ansprüche, **dadurch gekennzeichnet,** daß die Substratgreifer (13) in Abhängigkeit der Drehbewegung bzw. der Taktfrequenz des Drehtisches (12) gesteuert werden und ihre Arbeitsbewegung ausführen.

17. Transportvorrichtung nach einem der vorhergehenden Ansprüche, **dadurch gekennzeichnet**, daß der Drehtisch (12) zahlreiche bzw. vier bis zehn bzw. sieben bis neun bzw. acht Aufnahmestationen (15) aufweist und daß jeder Aufnahmestation (15) eine Prozeßstation bzw. eine Umschichtposition zugeordnet ist, von der aus das Substrat an eine außerhalb des Drehtisches (12) vorgesehene Station weitergegeben wird bzw. von dieser Station das Substrat (2) erhält.

18. Transportvorrichtung nach einem der vorhergehenden Ansprüche 8 bis 17, **dadurch gekennzeichnet,** daß der Beschichtungsstation (4) und der Druckstation (8) ein zweiarmiger Substratgreifer (13) und der Ablagestation ein zwei- oder dreiarmiger Substratgreifer (13) zugeordnet ist.

19. Transportvorrichtung nach einem der vorhergehenden Ansprüche, **dadurch gekennzeichnet,** daß der Drehtisch (12) einem Gehäuse (16) zugeordnet ist, das zur Erzeugung eines Überdrucks an eine Pumpenstation angeschlossen ist.

20. Transportvorrichtung nach einem der vorhergehenden Ansprüche, **dadurch gekennzeichnet,** daß der Drehtisch (12) als kreisförmige Scheibe ausgebildet ist.

21. Transportvorrichtung nach einem der vorhergehenden Ansprüche, **dadurch gekennzeichnet,** daß der Drehtisch (12) eine ebene Oberfläche aufweist.

22. Transportvorrichtung nach einem der vorhergehenden Ansprüche, **dadurch gekennzeichnet**, daß der Drehtisch (12) mit Bezug auf die Standfläche der Vorrichtung horizontal verlaufend angeordnet ist.

## Claims

1. Transport device (1) for conveying substrates (2), comprising an initial station (3) and several processing stations (4 to 9) which are arranged in a row or in a circle, that serve to receive the substrate (2), and to which the substrate (2) is passed by means of the transport device (1), which is configured as a turntable (12), and then delivered to a receiving and/or transfer station (5) which is associated with driven substrate grippers (13) for receiving and transferring the substrate from the turntable (12), characterized in that each receiving station (15) of the turntable can be associated with a processing device (4 through 9), in that the turntable (12) is driven at a constant cycle frequency, whereby the cycle frequency depends on the one processing station with the longest working duration, and in that there are several pivotable substrate grippers (13) configured with at least two arms that are across from the turntable and that serve to feed substrates to the processing stations situated in the vicinity of the periphery of the turntable (12).

2. Transport device according to Claim 1, characterized in that the substrate gripper (13) is configured with two or more arms.

3. Transport device according to Claim 1 or 2, characterized in that the substrate gripper (13) is mounted so that it can be pivoted and be adjusted in height in the vicinity of the transport device (1).

4. Transport device according to Claim 1, characterized in that the pivotable substrate gripper (13) is arranged at the periphery of the turntable (12).

5. Transport device according to one of the preceding claims, characterized in that, in order to shorten the cycle frequency of the turntable (12), the substrate gripper (13) feeds one substrate (2) at a time to one or more processing stations, which are situated outside of the turntable (12) and connected in parallel or in series, and on which identical or different working processes are carried out.

6. Transport device according to Claim 1, characterized in that there are at least as many receiving stations (15) on the turntable (12) as processing stations are needed for receiving the substrate (2), all of which are required for the complete processing of the substrate (2).

7. Transport device according to one of the preceding claims, characterized in that, in order to shorten the cycle frequency of the turntable (12), two or more identical working processes can be carried out simultaneously in parallel on two or more adjacent processing stations.

8. Transport device according to one of the preceding claims, characterized in that a one-arm or multi-arm gripper is situated in the vicinity of the initial station (3), of the coating station (4), of the printing station (9) and/or of the output station (10) so as to pass the substrate (2) from the turntable (12) to the satellite station or vice versa.

9. Transport device according to one of the preceding claims, characterized in that the first turntable (12) is associated with one or more turntables onto which the substrates coming from the first turntable (12) are deposited and briefly fed to the second turntable for further processing and are subsequently returned to the first turntable (12) or to another turntable or output station (10) once again.

10. Transport device according to one of the preceding claims, characterized in that the turntable (12) has one or more parking stations, at which no processing of the substrate takes place.

11. Transport device according to Claim 10, characterized in that the parking stations are situated outside of the turntable (12).

12. Transport device according to Claim 10 or 11, characterized in that the parking stations, with which one or more substrate grippers are associated, are arranged on a second turntable, which is situated in the vicinity of the periphery of the first turntable.

13. Transport device according to one of the preceding claims, characterized in that the distances between the individual receiving stations (15) on the turntable (12) are equal or different in size.

14. Transport device according to one of the preceding claims, characterized in that each substrate gripper (13) can receive several substrates (2) consecutively or simultaneously and, in this manner, to move the substrates between the individual stations or to receive the substrates from one station and pass them on to another station.

15. Transport device according to one of the preceding claims, characterized in that the substrate gripper (13) is mounted so that it can be pivoted horizontally and/or vertically and/or adjusted in height.

16. Transport device according to one of the preceding claims, characterized in that the substrate grippers (13) are controlled and carry out their working movement as a function of the rotational movement or of the cycle frequency of the turntable (12).

17. Transport device according to one of the preceding claims, characterized in that the turntable (12) has numerous or four to ten or seven to nine or eight receiving stations (15) and in that a processing station or a rearranging station is associated with each receiving station, from which the substrate is passed on to a station situated outside of the turntable (12) or which receives the substrate (2) from this station.

18. Transport device according to one of the preceding claims, characterized in that a two-arm substrate gripper (13) is associated with the coating station (4) and with the printing station (8), while a two-arm or three-arm substrate gripper (13) is associated with the depositing station.

19. Transport device according to one of the preceding claims, characterized in that the turntable (12) is associated with a housing (16), which is connected to a pumping station that generates an elevated pressure.

20. Transport device according to one of the preceding claims, characterized in that the turntable (12) is configured as a circular disk.

21. Transport device according to one of the preceding claims, characterized in that the turntable (12) has a flat surface.

22. Transport device according to one of the preceding claims, characterized in that the turntable (12) is arranged horizontally with respect to the standing surface of the device.

## Revendications

1. Dispositif de transport (1) pour l'acheminement de substrats (2), doté d'un poste de départ (3) et de plusieurs postes d'usinage (4 à 9) disposés en ligne ou en cercle et servant à recevoir le substrat (2), vers lesquels le substrat (2) est guidé par l'intermédiaire du dispositif de transport (1) conformé en table tournante circulaire (12) et ensuite transmis à un poste de réception et/ou de transfert (5) auquel sont assignés des preneurs de substrats actionnables (13) pour le retrait et le transfert du substrat provenant de la table tournante (12), **caractérisé en ce** qu'un dispositif d'usinage (4 à 9) peut être assigné à chacun des postes récepteurs (15) de la table tournante, que la table tournante (12) est actionnée à une cadence constante, cette cadence étant déterminée par un poste d'usinage quelconque présentant le temps de travail le plus long et que plusieurs preneurs de substrats (13) pivotant par rapport à la table tournante et présentant au moins deux bras sont prévus servant à charger en substrats les postes d'usinage prévus dans la zone périphérique de la table tournante.

2. Dispositif de transport selon la revendication 1, **caractérisé en ce** que le preneur de substrats (13) présente deux ou plusieurs bras.

3. Dispositif de transport selon l'une quelconque des revendications 1 ou 2, **caractérisé en ce** que le preneur de substrats (13) peut pivoter et est réglable en hauteur dans la zone du dispositif de transport (1).

4. Dispositif de transport selon la revendication 1, **caractérisé en ce** que le preneur de substrats (13) pivotant est disposé à la périphérie de la table tournante (12).

5. Dispositif de transport selon l'une quelconque des revendication précédentes, **caractérisé en ce** que, pour raccourcir la cadence de la table tournante (12), le preneur de substrats (13) achemine un substrat (2) respectivement vers un ou plusieurs postes d'usinage disposés en parallèle ou en ligne en dehors de la table tournante (12) et qui effectuent des opérations similaires ou différentes.

6. Dispositif de transport selon la revendication 1, **caractérisé en ce** que la table tournante (12) comporte un nombre de postes récepteurs (15) au moins égal au nombre de postes d'usinage nécessaires à la réception du substrat (2), lesdits postes étant tous nécessaires au traitement complet du substrat (2).

7. Dispositif de transport selon l'une quelconque des revendications précédentes, **caractérisé en ce** que, pour raccourcir la cadence de la table tournante (12), deux ou plusieurs opérations identiques peuvent être effectuées simultanément en parallèle dans deux ou plusieurs postes d'usinage juxtaposés.

8. Dispositif de transport selon l'une quelconque des revendications précédentes, **caractérisé en ce** qu'un preneur (13) à deux ou plusieurs bras est prévu dans la zone du poste de départ (3), d'un poste d'enduction (4), d'un poste d'impression (9) et/ou d'un poste de sortie (10) qui achemine le substrat (2) de la table tournante (12) vers le poste satellite ou vice versa.

9. Dispositif de transport selon l'une quelconque des revendications précédentes, **caractérisé en ce** qu'une ou plusieurs tables tournantes sont assignées à la première table tournante (12) qui reçoivent les substrats (2) venant de la première table tournante (12), les substrats (2) étant amenés à la deuxième table tournante en vue de leur traitement ultérieur, pour être ensuite réacheminés sur la première table tournante (12) ou envoyés à une autre table tournante ou un poste de sortie (10).

10. Dispositif de transport selon l'une quelconque des revendications précédentes, **caractérisé en ce** que la table tournante (12) présente un ou plusieurs postes de stationnement dans lesquels le substrat n'est soumis à aucun traitement.

11. Dispositif de transport selon la revendication 10, **caractérisé en ce** que les postes de stationnement sont prévus en dehors de la table tournante (12).

12. Dispositif de transport selon l'une quelconque des revendications 10 ou 11, **caractérisé en ce** que les postes de stationnement, auxquels sont assignés un ou plusieurs preneurs de substrats, sont disposés sur une deuxième table tournante prévue dans la zone périphérique de la première table tournante.

13. Dispositif de transport selon l'une quelconque des revendications précédentes, **caractérisé en ce** que les écarts entre les différents postes récepteurs (15) sur la table tournante sont égaux ou différents.

14. Dispositif de transport selon l'une quelconque des revendications précédentes, **caractérisé en ce** que chaque preneur de substrats (13) peut prendre plusieurs substrats (2) l'un après l'autre ou à la fois afin de les transporter entre les différents postes ou de les prendre de l'un de postes pour les remettre à un autre poste.

15. Dispositif de transport selon l'une quelconque des revendications précédentes, caractérisé en ce que le preneur de substrats (13) peut pivoter à l'horizontale et/ou à la verticale et/ou peut être réglé en hauteur.

16. Dispositif de transport selon l'une quelconque des revendications précédentes, **caractérisé en ce** que les preneurs de substrats (13) sont commandés en fonction du mouvement de rotation ou de la cadence de la table tournante (12) pour effectuer leur mouvement de travail.

17. Dispositif de transport selon l'une quelconque des revendications précédentes, **caractérisé en ce** que la table tournante (12) présente de nombreux, ou quatre à dix, ou sept à neuf, ou huit postes récepteurs (15) et qu'un poste d'usinage ou une position de regroupage est assigné à chaque poste récepteur (15), à partir duquel le substrat est transmis à un poste prévu en dehors de la table tournante (12) ou qui reçoit le substrat (2) dudit poste.

18. Dispositif de transport selon l'une quelconque des revendications 8 à 17, **caractérisé en ce** qu'un preneur de substrats (13) à deux bras est assigné au poste d'enduction (14) et au poste d'impression (8), et un preneur de substrats (13) à deux ou trois bras au poste de dépôt.

19. Dispositif de transport selon l'une quelconque des revendications précédentes, **caractérisé en ce** que la table tournante (12) est assignée à un boîtier (16) qui est raccordé à une station de pompage pour établir une surpression.

20. Dispositif de transport selon l'une quelconque des revendications précédentes, **caractérisé en ce** que la table tournante (12) est conformée en disque circulaire.

21. Dispositif de transport selon l'une quelconque des revendications précédentes, **caractérisé en ce** que la table tournante (12) présente une surface plane.

22. Dispositif de transport selon l'une quelconque des revendications précédentes, **caractérisé en ce** que la table tournante (12) est disposée horizontalement par rapport à la base du dispositif.
